# EUROPÄISCHE PATENTSCHRIFT

(11) **EP 2 894 684 B1**
(45) Veröffentlichungstag und Bekanntmachung des Hinweises auf die Patenterteilung: **09.01.2019**
(21) Anmeldenummer: 14194122.9
(22) Anmeldetag: 20.11.2014
(51) Int. Cl.: H01L 41/27, H01L 41/193, H01L 41/047, H01L 41/293, H01L 41/297, H02N 2/18

(54) **EAP-Vorrichtung sowie Vefahren zur Herstellung der EAP-Vorrichtung**
EAP device and method for producing said EAP device
Dispositif EAP et procédé de fabrication du dispositif EAP

(30) Priorität: 09.01.2014 DE 102014200241
(43) Veröffentlichungstag der Anmeldung: 15.07.2015
(73) Patentinhaber: ROBERT BOSCH GMBH, 70442 Stuttgart (DE)
(72) Erfinder: Schaefer, Stefan, 70825 Korntal-Muenchigen (DE); Denes, Istvan, 71336 Waiblinge/Hohenacker (DE); Kuhnen, Klaus, 66128 Saarbruecken (DE); Fischer, Marc, 73262 Reichenbach (DE)

(56) Entgegenhaltungen:
- EP-A2- 2 136 418
- WO-A1-2008/112354
- WO-A1-2013/122110
- WO-A2-2006/123317
- DE-A1-102008 039 757
- DE-A1-102012 208 557

## Beschreibung

### Stand der Technik

Elektroaktive Polymere, kurz allgemeinhin als EAP bekannt, verändern ihre Form durch das Anlegen einer elektrischen Spannung. Daher können EAP als Aktoren verwendet werden. EAP ermöglichen aber auch einen generatorischen Betrieb, bei dem eine mechanisch verursachte Dehnung des EAPs direkt in elektrische Energie umgewandelt wird. Derartige Energiewandler werden als EAP-Generatoren bezeichnet. Die Umwandlung der Dehnung des EAPs in elektrische Energie erfolgt auf kapazitiver Basis durch Verschiebung von Ladungen.

Aus der Druckschrift DE 10 2011 086 256 A1 ist ein Wellenenergiewandler zur Gewinnung elektrischer Energie bekannt. Der Wellenenergiewandler umfasst einen Bereich, der einem Gewässer mit Wellengang offen zugewandt ist, und mit einen beweglichen flächigen Druckkraftaufnehmer versehen ist. Ferner weist der Wellenenergiewandler ein elektrisch-mechanisches Wandlermodul auf, das mit dem Druckkraftaufnehmer mechanisch gekoppelt ist. Das Wandlermodul ist zu einer Umwandlung einer Eigenbewegung des Druckkraftaufnehmers in elektrische Spannung ausgebildet, wobei das Wandlermodul als mindestens ein elektroaktives Polymer ausgebildet ist.

Die Druckschrift DE 10 2012 208 557 A1 betrifft eine Vorrichtung zur Umwandlung mechanischer Energie in elektrische Energie umfassend einen ersten Generator mit elektrischen Elektroden und einem elektroaktiven Polymer, einen zweiten Generator mit elektrischen Elektroden und einem elektroaktiven Polymer und einem Aktuator zur Einbringung mechanischer Energie in den ersten und zweiten Generator.

Die Druckschrift WO 2013 / 122110 A1 beschreibt ein piezoelektrisches Element, das eine Vielzahl an streifenförmigen und flexiblen Folien umfasst, wobei die Folien ein dielektrisches Elastomer umfassen, auf das eine dehnbare Elektrodenschicht auflaminiert ist. Die Vielzahl von Folien ist kreuzweise aufeinander gestapelt.

Die Druckschrift EP 2 136 418 A2, die den nächstkommenden Stand der Technik darstellt, offenbart einen Faltaktor oder Faltsensor, mit einer Vielzahl nebeneinander angeordneter Elektrodenabschnitte und mit zwischen zwei benachbarten Elektrodenabschnitten angeordnetem deformierbarem, insbesondere elektroaktiven, Dielektrikum. Der Faltaktor bzw. Faltsensor wird durch Ineinanderfalten von mindestens zwei Elektrostreifen gebildet.

### Offenbarung der Erfindung

Im Rahmen der Erfindung wird ein Verfahren zur Herstellung einer EAP-Vorrichtung mit den Merkmalen des Anspruchs 1 und eine durch das Verfahren hergestellte EAP-Vorrichtung mit den Merkmalen des Anspruchs 8 offenbart. Bevorzugte oder vorteilhafte Ausführungsformen der Erfindung ergeben sich aus den Unteransprüchen, der nachfolgenden Beschreibung sowie den beigefügten Figuren.

Erfindungsgemäß wird somit eine EAP-Vorrichtung mit mindestens einem EAP-Stapel sowie ein Verfahren zur Herstellung der EAP-Vorrichtung vorgeschlagen. Das EAP, auch als elektroaktives Polymer bekannt, ist insbesondere ausgebildet, elektrische Energie in mechanische Arbeit umzuwandeln und/oder vice versa. EAP ermöglichen einen generatorischen Betrieb, bei dem mechanische Dehnungsenergie direkt in elektrische Energie umgewandelt wird. Beispielsweise ist der mindestens eine EAP-Stapel als ein EAP-Generator zur Erzeugung elektrischer Energie ausgebildet. Alternativ kann der mindestens eine EAP-Stapel als ein EAP-Aktor ausgebildet sein. Bei dem EAP-Stapel als der EAP-Aktor kann die gewünschte Expansion und Kontraktion angesteuert werden. Der mindestens eine EAP-Stapel umfasst eine Mehrzahl an in einer Längsachse aufeinander angeordnete Schichten, wobei die Schichten Elektroden- und Dielektrikumsschichten aufweisen. Unter der Mehrzahl der Schichten werden mindestens drei, vorzugsweise mindestens fünf Schichten verstanden. Die Dielektrikumsschichten sind als EAP-Schichten mit jeweils mindestens einem Dielektrikumsabschnitt ausgebildet. Die Elektrodenschichten sind als EAP-Schichten mit jeweils mindestens einem Elektrodenabschnitt ausgebildet. Die Dielektrikums- und Elektrodenschichten als die EAP-Schichten sind verformbar, insbesondere elastisch verformbar ausgebildet. Als eine bevorzugte Schichtabfolge weist der EAP-Stapel mindestens zwei Elektrodenschichten mit einer Elektrode und einer Gegenelektrode als die Elektrodenabschnitte sowie mindestens oder genau eine zwischen den zwei Elektrodenschichten angeordnete Dielektrikumsschicht mit einem Dielektrikum als der Dielektrikumsabschnitt auf. Insbesondere sind die Elektroden- und Dielektrikumsschichten in einer zur Längsachse bevorzugt regelmäßigen Schichtabfolge aufeinander gestapelt. Besonders bevorzugt sind die Elektroden- und Dielektrikumsschichten in einer Sandwichbauweise gestapelt.

Im Rahmen der Erfindung wird vorgeschlagen, dass die Elektroden- und/oder die Dielektrikumsschichten als EAP-Folien ausgebildet sind.

Die Elektroden- und der Dielektrikumsschichten weisen durch die Fertigung aus dem EAP ein gleiches oder ähnliches Dehnungsverhalten auf. Somit können sich die Elektroden- und Dielektrikumsschichten vorteilhafterweise zumindest näherungsweise gleichermaßen elastisch ausdehnen. Folglich ist die Gefahr des Ablösens der Elektroden- und Dielektrikumsschichten durch die ständige Kompression und Dekompression verhindert oder zumindest reduziert. Des Weiteren werden die Dielektrikumsschichten durch das ähnliche Dehnungsverhalten bei ihrer Ausdehnung durch die Elektrodenschichten nicht behindert bzw. kann das Ausdehnungsverhalten der Dielektrikumsschichten voll ausgenutzt werden. Auf diese Weise ist eine Verbesserung des Wirkungsgrads und der Lebensdauer erzielt.

Ein weiterer wesentlicher Vorteil der EAP-Folien ist ihre im Vergleich zu plattenförmigen Schichten geringe Schichtdicke und Nachgiebigkeit. Beispielsweise weisen die EAP-Folien eine Schichtdicke weniger als 0,1 mm, insbesondere weniger als 0,05 mm, im Speziellen weniger als 0,005 mm auf. Hierbei können die Elektroden- und die Dielektrikumsschichten eine unterschiedliche, jedoch bevorzugt die gleiche Schichtdicke aufweisen. Insbesondere die sich hierdurch ergebende flexible Handhabung der EAP-Folien ermöglicht eine kostengünstige Endlosfertigung der EAP-Folien. Folglich ist der EAP-Stapel vorteilhafterweise in einer Großserienproduktion in einem Folien-Coextrusionsverfahren wirtschaftlich herstellbar. Ferner ermöglichen die EAP-Folien eine platzsparende Ausführung des EAP-Stapels.

Besonders bevorzugt sind die EAP-Schichten aus einem trockenen EAP gebildet. Vorzugsweise ist das EAP der Elektrodenschicht, insbesondere des Elektrodenabschnitts ein elektrostriktives und/oder ein ferroelektrisches Polymer. Weiterhin ist bevorzugt, dass das EAP der Dielektrikumsschicht, insbesondere des Dielektrikumsabschnitts ein dielektrisches Elastomer ist. Das dielektrische Elastomer ist z. B. ein organisches Elastomer, wie z. B. EPDM, NBR, HNBR, als mögliche Alternative ein thermoplastisches Elastomer. Besonders bevorzugt ist das dielektrische Elastomer ein Silikon und/oder ein Acryl.

Erfindungsgemäß weisen die als EAP-Folien ausgebildeten Elektrodenschichten in der flächigen Erstreckung jeweils mindestens oder genau zwei Leitungsabschnitte auf, wobei einer der Leitungsabschnitte den Elektrodenabschnitt und der andere Leitungsabschnitt einen Sammelelektrodenabschnitt bildet. Insbesondere bildet der Sammelelektrodenabschnitt in Längsrichtung des EAP-Stapels eine elektrisch leitfähige Verbindungsstelle für zwei Elektroden gleichen Potentials. Vorzugsweise weisen der Elektroden- und der Sammelelektrodenabschnitt der jeweiligen EAP-Folie ein unterschiedliches Potential auf. Erfindungsgemäß umfassen die als EAP-Folien ausgebildeten Elektrodenschichten in der flächigen Erstreckung jeweils mindestens oder genau einen Isolationsabschnitt, der die Leitungsabschnitte elektrisch voneinander isoliert. Die flächige Erstreckung der Elektrodenschichten verläuft insbesondere senkrecht zur Längsachse des EAP-Stapels. Insbesondere sind die Elektrodenschichten durch die Ausbildung als die EAP-Folien einteilig gefertigt. Somit sind die Leitungs- und Isolationsabschnitte insbesondere einteilig miteinander verbunden. Vorteilhaft an der einteiligen Fertigung der Leitungsabschnitte und des Isolationsabschnitts in der EAP-Folie ist der Montageaufwand durch eine Reduzierung der Einzelteile gesenkt und die Prozesskette verkürzt, was zu einer Verringerung der Fertigungskosten führt.

Bei einer weiteren bevorzugten Ausführungsform weisen die als EAP-Folien ausgebildeten Dielektrikumsschichten in der flächigen Erstreckung jeweils mindestens oder genau zwei Leitungsabschnitte auf, die durch den Dielektrikumsabschnitt elektrisch voneinander isoliert sind. Insbesondere bilden die Leitungsabschnitte jeweils einen Sammelelektrodenabschnitt. Vorzugsweise bildet der Sammelelektrodenabschnitt in Längsrichtung des EAP-Stapels eine Verbindungsstelle für zwei Elektrodenabschnitte des gleichen Potentials. Insbesondere weisen der Sammelelektrodenabschnitt und der Elektrodenabschnitt der jeweiligen EAP-Folie ein unterschiedliches Potential auf. Die flächige Erstreckung der Dielektrikumsschichten verläuft insbesondere senkrecht zur Längsachse des EAP-Stapels. Insbesondere sind die Dielektrikumsschichten durch die Ausbildung als die EAP-Folien einteilig gefertigt. Somit sind die Leitungs- und Isolationsabschnitte insbesondere einteilig miteinander verbunden. Durch die einteilige Fertigung der Leitungsabschnitte und des Dielektrikumsabschnitts ist der Montageaufwand gesenkt und die Prozesskette verkürzt, was zu einer Verringerung der Fertigungskosten führt.

In einer möglichen Ausgestaltung der Erfindung umfasst oder bildet der EAP-Stapel eine Sammelelektrode und eine Gegensammelelektrode. Durch die Sammel- und Gegensammelelektrode sind zusammengehörige Elektrodenabschnitte, das heißt Elektrodenabschnitte mit dem gleichen Potential, elektrisch miteinander verbunden. Vorzugsweise ist die Sammelelektrode durch einen der Sammelelektrodenabschnitte der Dielektrikumsschichten und durch einen der Leitungsabschnitte der Elektrodenschichten gebildet. Weiterhin ist bevorzugt, dass die Gegensammelelektrode durch den anderen Sammelelektrodenabschnitt der Dielektrikumsschichten und durch den anderen Leitungsabschnitt der Elektrodenschichten gebildet ist. Insbesondere bilden die Sammelelektrodenabschnitte der Elektroden- und/oder Dielektrikumsschichten Verbindungsbereiche von zwei in Längsrichtung zur Längsachse benachbarten Elektrodenabschnitten des gleichen Potentials. Insbesondere sind die Elektroden- und Dielektrikumsschichten stoffschlüssig miteinander verbunden. Auf diese Weise sind zusätzliche Kontaktierungselemente, die eine Kontaktierung zwischen den Elektroden und Gegenelektroden bereitstellen, nicht nötig. Die stoffschlüssige Verbindung kann vorteilhafterweise in einer Großserienfertigung automatisiert und sachgemäß bereitgestellt werden. Zudem ist ein stabiler und belastbarer Direktkontakt mit geringen elektrischen Widerstand umgesetzt.

Bevorzugt ist, dass die Sammelelektrode als ein Elektrodenkamm und die Gegensammelelektrode als ein Gegenelektrodenkamm ausgebildet sind, die ineinander greifen und durch die Isolationsabschnitte und die Dielektrikumsabschnitte voneinander isoliert sind. Die Sammel- und die Gegensammelelektrode erzielt durch die Kammstruktur eine einfache und kompakte Bauweise des EAP-Stapels.

Eine bevorzugte Ausführungsform der Erfindung sieht vor, dass die Leitungsabschnitte und/oder die Sammelelektrodenabschnitte durch elektrisch leitende Additive im EAP gebildet sind. Vorzugsweise sind die elektrisch leitenden Additive kleine elektrisch leitfähige Partikel. Beispielsweise sind die elektrisch leitenden Additive aus Kohlenstoffpartikel, insbesondere aus Kohlenstoffnanoröhren, aus Rußpartikeln und/oder aus Metallpartikeln, insbesondere aus Metallfäden gebildet. Auf diese Weise ist die elektrische Leitfähigkeit in dem EAP erzielt, wobei das Dehnungsverhalten des EAPs vorteilhafterweise weitgehend beibehalten wird.

In einer möglichen Ausgestaltung der Erfindung ist die EAP-Vorrichtung als ein Wellenenergiewandler zur Gewinnung elektrischer Energie aus der Bewegungsenergie von Wasserwellen ausgebildet. Besonders bevorzugt ist der mindestens eine EAP-Stapel als der EAP-Generator ausgebildet, die auf ihn übertragene Bewegungsenergie in die elektrische Energie umzuwandeln.

Einen weiteren Gegenstand der Erfindung betrifft die Verwendung einer EAP-Endloshybridfolie für einen EAP-Stapel der EAP-Vorrichtung, wobei die EAP-Endloshybridfolie eine Mehrzahl an Elektrodenschichten mit Leitungs- und Isolationsabschnitten und/oder eine Mehrzahl an Dielektrikumsschichten mit Leitungs- und Dielektrikumsabschnitten umfasst.

Gegenstand der Erfindung ist ein Verfahren zur Herstellung einer EAP-Vorrichtung nach der vorhergehenden Beschreibung. Es werden die Elektrodenschichten und die Dielektrikumsschichten als EAP-Folien bereitgestellt. In einem weiteren Fertigungsschritt werden die EAP-Folien in einer Längsachse aufeinander angeordnet und miteinander gefügt.

In einer möglichen Ausgestaltung die nicht Teil der Erfindung ist, ist es möglich, dass die EAP-Folien zunächst zugeschnitten werden und anschließend aufeinander angeordnet und zu dem EAP-Stapel miteinander gefügt werden. Jedoch ist ein wesentlicher Vorteil der Dielektrikums- und Elektrodenschichten als die EAP-Folien die dünne Schichtdicke und somit die Möglichkeit der Endlosfertigung. Vor diesem Hintergrund ist erfindungsgemäß, dass die EAP-Folien mittels eines Folien-Coextrusionsverfahrens miteinander gefügt werden. Bei dem Folien-Coextrusionsverfahren handelt es sich um ein Verfahren zur Erzeugung von Extrudaten, die aus mehreren Schichten artgleicher oder artfremder Kunststoffe gefertigt sind. Insbesondere werden bei dem Folien-Coextrusionsverfahren mehrere EAP-Endloshybridfolien, die eine Mehrzahl an Dielektrikums- und/oder Elektrodenschichten umfassen, jeweils von einer Rolle abgerollt und durchlaufen ungeschnitten das Aufeinanderstapeln und Fügen der zugehörigen Dielektrikums- und Elektrodenschichten. Hierfür ist bevorzugt, dass die EAP-Endloshybridfolien in einer Längsrichtung jeweils die abwechselnd angeordneten Leitungs- und Dielektrikumsabschnitten der Dielektrikumsschichten und/oder Leitungs- und Isolationsabschnitten der Elektrodenschichten aufweisen. Erfindungsgemäß ist nach dem Fügen ein EAP-Endlosstapel fertiggestellt. In einem Folgeschritt kann der EAP-Endlosstapel in einzelne EAP-Stapel zugeschnitten werden. Das Folien-Coextrusionsverfahrens stellt einen stabilen Direktkontakt der EAP-Folien zueinander sicher. Zudem setzt das Folien-Coextrusionsverfahren bei einer Großserienproduktion eine preisgünstige Bereitstellung des EAP-Stapels um.

Weitere Merkmale, Vorteile und Wirkungen der Erfindungen ergeben sich aus der nachfolgenden Beschreibung bevorzugter Ausführungsbeispiele der Erfindung. Dabei zeigen:
- Figur 1: einen EAP-Stapel als ein bevorzugtes Ausführungsbeispiel der Erfindung;
- Figur 2: den EAP-Stapel aus Figur 1 mit einer Kammstruktur;
- Figur 3: die Bereitstellung einzelner EAP-Endloshybridfolien zur Fertigung des EAP-Stapels aus Figur 1 mittels eines Folien-Coextrusionsverfahrens.

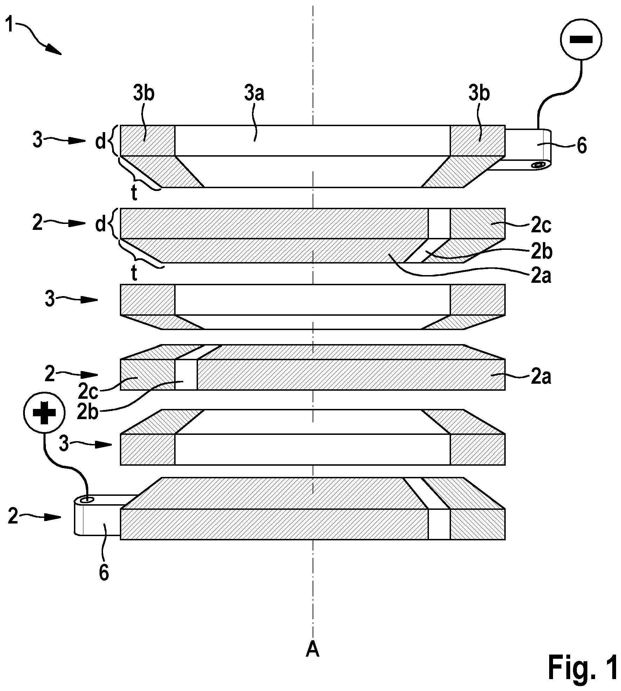

Figur 1 zeigt einen EAP-Stapel 1 als ein bevorzugtes Ausführungsbeispiel der Erfindung. Das EAP ist ein elektroaktives Polymer, das je nach Betriebsrichtung elektrische Energie in mechanische Arbeit umwandelt oder mechanische Arbeit in elektrische Energie umwandelt. Der EAP-Stapel 1 kann z. B. als ein EAP-Generator oder als ein EAP-Aktor ausgebildet sein.

Der EAP-Stapel 1 umfasst eine Mehrzahl an in einer Längsachse A aufeinander angeordnete Schichten, wobei die Schichten Elektroden- und Dielektrikumsschichten 2, 3 aufweisen. Bei diesem Ausführungsbeispiel umfasst der EAP-Stapel 1 insgesamt sechs EAP-Schichten 2, 3, wobei die Anzahl je nach gewünschter mechanischer bzw. elektrischer Energiegewinnung geringer oder höher ausfallen kann. In der Figur 1 sind die Elektroden- und Dielektrikumsschichten 2, 3 der Übersicht halber in Längsrichtung beabstandet zueinander angeordnet, sind jedoch zur Bildung des EAP-Stapels 1 zu einem Stapel gefügt. Z. B. sind die Elektroden- und Dielektrikumsschichten 2, 3 stoffschlüssig miteinander verbunden. Die Elektroden- und die Dielektrikumsschichten 2, 3 sind in einer zur Längsachse A des EAP-Stapels 1 regelmäßigen Schichtabfolge aufeinander gestapelt.

Die Elektrodenschichten 2 weisen in der flächigen Erstreckung jeweils zwei Leitungsabschnitte 2a, 2c und einen Isolationsabschnitt 2b auf, wobei die Leitungsabschnitte 2a, 2c durch den Isolationsabschnitt 2b elektrisch voneinander isoliert sind. Der größere der Leitungsabschnitte bildet einen Elektrodenabschnitt 2a und der kleinere Leitungsabschnitt 2c einen Sammelelektrodenabschnitt 2c. Bei diesem Ausführungsbeispiel sind die Elektrodenabschnitte 2a in Längsrichtung abwechselnd als Elektroden und Gegenelektroden ausgebildet. Der Sammelelektrodenabschnitt 2c der Elektrodenschichten 2 bildet in Längsrichtung eine elektrisch leitende Verbindungsstelle für zwei Elektrodenabschnitte 2a des gleichen Potentials.

In der flächigen Erstreckung, d. h. in radialer Richtung der Längsachse A aus betrachtet, sind der Elektroden- und der Sammelelektrodenabschnitt 2a, 2c an zwei sich gegenüberliegenden Endbereichen der Elektrodenschicht 2 angeordnet. Der Elektroden-, Isolations- und der Sammelelektrodenabschnitt 2a, 2b, 2c erstrecken sich über die gesamte Schichtdicke d der Elektrodenschicht 2. Die Schichtdicke d erstreckt sich in Richtung der Längsachse A. Ferner erstrecken sich der Elektroden-, Isolations- und Sammelelektrodenabschnitt 2a, 2b, 2c über die gesamte Schichttiefe t der Elektrodenschicht 2. Die Schichtdicke t erstreckt sich senkrecht zur Längsachse A. Beispielsweise nimmt der Elektrodenabschnitt 2a von dem Gesamtvolumen der Elektrodenschicht 2 einen Volumenanteil von mindestens 20 Prozent, insbesondere von mindestens 40 Prozent, im Speziellen von mindestens 60 Prozent ein. Z. B. sind die Elektrodenschichten 2 des EAP-Stapels 1 baugleich ausgebildet.

Die Dielektrikumsschichten 3 weisen in der flächigen Erstreckung jeweils einen Dielektrikumsabschnitt 3a sowie zwei Leitungsabschnitte 3b auf, die durch den Dielektrikumsabschnitt 3a elektrisch voneinander isoliert sind. Die Leitungsabschnitte 3b sind jeweils als ein Sammelelektrodenabschnitt 3b ausgebildet. Die Sammelelektrodenabschnitte 3b bilden mittel- oder unmittelbar die elektrisch leitende Verbindungsstelle für zwei Elektrodenabschnitte 2a. Die Dielektrikumsabschnitte 3a sind in Längsrichtung des EAP-Stapels 1 jeweils als ein Dielektrikum zwischen zwei Elektrodenabschnitten 2a, insbesondere zwischen einer Elektrode und einer Gegenelektrode angeordnet. Die Dielektrikumsabschnitte 3a sind mit den jeweils in Längsrichtung benachbarten Isolationsschichten 2b der Elektrodenschichten 2 verbunden. Somit sind die Elektrodenabschnitte 2a unterschiedlichen Potentials elektrisch voneinander isoliert. In radialer Richtung der Längsachse A aus betrachtet sind die Sammelelektrodenabschnitte 3b an zwei sich gegenüberliegenden Endbereichen der Dielektrikumsschicht 3 angeordnet. Die Sammelelektrodenabschnitte 3b sind mit den jeweils in Längsrichtung benachbarten Elektroden- bzw. Sammelelektrodenabschnitten 2a, 2c verbunden. Die Sammelelektrodenabschnitte 2c, 3b weisen die gleiche Baugröße auf.

Der Dielektrikums- und der Sammelelektrodenabschnitt 3a, 3b erstrecken sich über die gesamte Schichtdicke d der Dielektrikumsschicht 3. Ferner erstrecken sich der Dielektrikums- und die Sammelelektrodenabschnitte 3a, 3b über die gesamte Schichttiefe t der Dielektrikumsschicht 3. Beispielsweise nimmt der Dielektrikumsabschnitt 3a von dem Gesamtvolumen der Dielektrikumsschicht 3 einen Volumenanteil von mindestens 20 Prozent, insbesondere von mindestens 30 Prozent, insbesondere von mindestens 50 Prozent ein. Z. B. sind die Dielektrikumsschichten 3 des EAP-Stapels 1 baugleich ausgebildet. Die in Längsrichtung benachbarten Leitungs- bzw. Sammelelektrodenabschnitte 2a, 2c, 3b der Elektroden- und Dielektrikumsschichten 2, 3 sind für die elektrische Kontaktierung an den gleichen Randbereichen des EAP-Stapels 1 angeordnet.

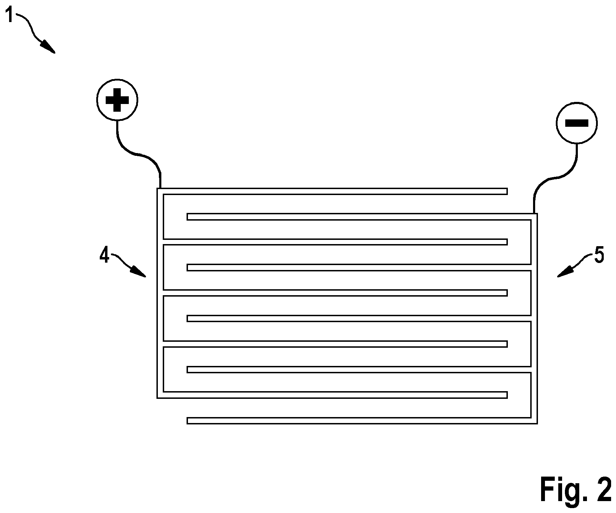

Wie in Figur 2 gut erkennbar, umfasst der EAP-Stapel 1 eine Sammelelektrode 4 und eine Gegensammelelektrode 5. Durch die Sammelelektrode 4 und Gegensammelelektrode 5 sind zusammengehörige Elektrodenabschnitte 2a elektrisch miteinander verbunden. Die Sammelelektrode 4 ist durch einen der Sammelelektrodenabschnitte 3b der Dielektrikumsschichten 3 und durch einen der Leitungsabschnitte 2a/2c der Elektrodenschichten 2 gebildet. Die Gegensammelelektrode 5 ist durch den anderen Sammelelektrodenabschnitt 3b der Dielektrikumsschichten 3 und durch den jeweils anderen Leitungsabschnitt 2a/2c der Elektrodenschichten 2 gebildet. Somit sind die Elektrodenabschnitte 2a mit dem jeweils gleichen Potential über die Sammelelektrodenabschnitte 3b der Dielektrikumsschichten 3 elektrisch miteinander verbunden. Wie in Figur 1 dargestellt, umfassen die Sammelelektrode 4 und die Gegensammelelektrode 5 jeweils einen Elektrodenanschluss 6. Auf diese Weise ist z. B. die elektrische Energie von dem EAP-Stapel 1 ableitbar.

Die Sammelelektrode 4 ist als ein Elektrodenkamm und die Gegensammelelektrode 5 als ein Gegenelektrodenkamm ausgebildet, die ineinander greifen und durch die miteinander verbundenen Isolations- und Dielektrikumsabschnitte 2b, 3a elektrisch voneinander isoliert sind. Bei diesem Ausführungsbeispiel sind die Elektrodenschichten 2 in der in Figur 1 dargestellten Vorderansicht zu der jeweils in Längsrichtung nächsten Elektrodenschicht 2 um 180° gedreht angeordnet, so dass die Kammstruktur ermöglicht ist.

Die Elektroden- und die Dielektrikumsschichten 2, 3 sind als EAP-Folien ausgebildet. Z. B. weisen die Elektroden- und die Dielektrikumsschichten 2, 3 als die EAP-Folien eine Schichtdicke d weniger als 0,1 mm auf. Die EAP-Folien können vorteilhafterweise aus EAP-Endloshybridfolien gefertigt werden. Die EAP-Endloshybridfolien ermöglichen wiederum die wirtschaftliche Herstellung des EAP-Stapels 1 in einem Folien-Coextrusionsverfahren. Auf diese Weise ist eine einfache, kostengünstige und zuverlässige Fertigung des EAP-Stapels 1 erzielt.

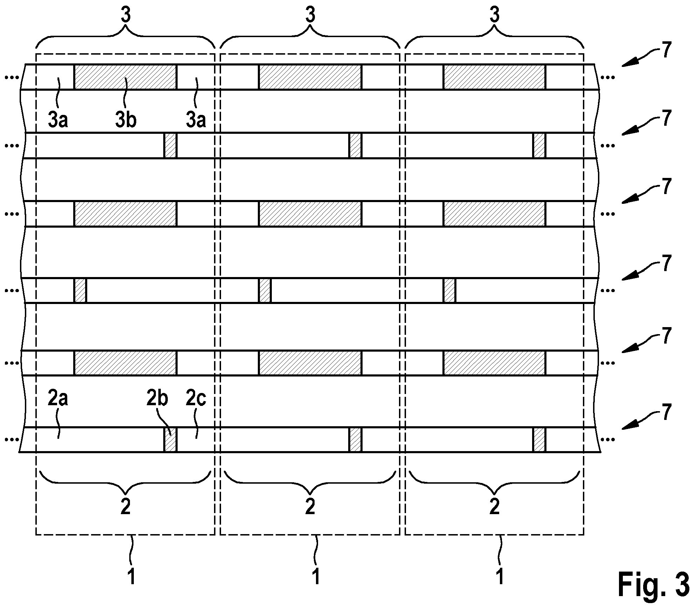

Anhand der Figur 3 soll das Folien-Coextrusionsverfahren des in Figur 1 dargestellten EAP-Stapels 1 als ein mögliches Fertigungsbeispiel erläutert werden. Für die Elektroden- und Dielektrikumsschichten 2, 3 des EAP-Stapels 1 werden die EAP-Endloshybridfolien 7 jeweils von einer Rolle abgerollt. Rein beispielhaft sind hier ein Ausschnitt von sechs abgerollten EAP-Endloshybridfolien 7 dargestellt. Drei der EAP-Endloshybridfolien 7 umfassen eine Mehrzahl an Elektrodenschichten 2, wobei die weiteren drei EAP-Endloshybridfolien 7 eine Mehrzahl an Dielektrikumsschichten 3 aufweisen. Somit umfassen die EAP-Endloshybridfolien 7 in einer Längsrichtung die abwechselnd angeordneten Leitungs- und Isolationsabschnitte 2a, 2b, 2c der Elektrodenschichten 2 bzw. die Leitungs- und Dielektrikumsabschnitte 3a,3b der Dielektrikumsschichten 3.

Die abgerollten EAP-Endloshybridfolien 7 sind in Richtung des zu fertigenden EAP-Stapels 1 abwechselnd mit den Elektrodenschichten 2 und den Dielektrikumsschichten 3 angeordnet. In einem Folgeschritt werden die abgerollten EAP-Endloshybridfolien 7 zum EAP-Stapel 1 vereinigt. Hierfür werden die EAP-Endloshybridfolien 7 mit einem Schmelz-Klebstoff beschichtet und zu einem Laminat gefügt. Die EAP-Endloshybridfolien 7 sind derart zueinander angeordnet, dass die Elektroden- und Dielektrikumsschichten 2, 3 bei der Vereinigung zu einem EAP-Endlosverbund in der gewünschten Form kontaktierend zueinander angeordnet sind. Folgend kann der EAP-Endlosverbund zur Lagerung auf eine Rolle aufgewickelt, alternativ gleich in einzelne EAP-Stapel 1 zugeschnitten werden.

## Patentansprüche

1. Verfahren zur Herstellung einer EAP-Vorrichtung, wobei die EAP-Vorrichtung mindestens einem EAP-Stapel (1) umfasst,
wobei der mindestens eine EAP-Stapel (1) eine Mehrzahl an in einer Längsachse aufeinander angeordneten Schichten aufweist,
wobei die Schichten Elektroden- und Dielektrikumsschichten (2, 3) umfassen, wobei die Dielektrikumsschichten (3) als EAP-Schichten mit jeweils mindestens einem Dielektrikumsabschnitt (3a) ausgebildet sind,
wobei die Elektrodenschichten (2) als EAP-Schichten mit jeweils mindestens einem Elektrodenabschnitt (2a) ausgebildet sind,
wobei die Elektroden- und/oder die Dielektrikumsschichten (2, 3) als EAP-Folien ausgebildet sind,
wobei die als EAP-Folie ausgebildete Elektrodenschicht (2) in der flächigen Erstreckung mindestens zwei Leitungsabschnitte (2a, 2c) aufweist, wobei einer der Leitungsabschnitte den Elektrodenabschnitt (2a) und der andere Leitungsabschnitt einen Sammelelektrodenabschnitt (2c) bildet, und wobei die als EAP-Folie ausgebildete Elektrodenschicht (2) einen Isolationsabschnitt (2b) aufweist, der den ersten und zweiten Leitungsabschnitt (2a, 2c) voneinander elektrisch isoliert,
wobei die Elektrodenschichten (2) und Dielektrikumsschichten (3) als EAP-Folien (2, 3) bereitgestellt werden, wobei die EAP-Folien mittels eines Folien-Coextrusionsverfahrens in einer Längsachse (A) aufeinander angeordnet miteinander gefügt werden, und wobei nach dem Fügen der EAP-Stapel als EAP-Endlosstapel ausgebildet ist und/oder zu einzelnen EAP-Stapel zugeschnitten wird,
wobei die EAP-Folien (2, 3) aus mindestens einer EAP-Endloshybridfolie (7) mit in einer Längsrichtung der EAP-Endloshybridfolie (7) abwechselnd angeordneten Leitungs- und Dielektrikumsabschnitten (3a, 3b) und/oder Leitungs- und Isolationsabschnitten (2a, 2b, 2c) bereitgestellt werden, **dadurch gekennzeichnet, dass** zur Vereinigung der EAP-Endloshybridfolien (7) zum EAP-Stapel (1) die EAP-Endloshybridfolien (7) mit einem Schmelz-Klebstoff beschichtet werden und zu einem Laminat gefügt werden.

2. Verfahren zur Herstellung einer EAP-Vorrichtung nach Anspruch 1, **dadurch gekennzeichnet, dass** die als EAP-Folie ausgebildete Dielektrikumsschicht (3) in der flächigen Erstreckung mindestens zwei Leitungsabschnitte (3b) aufweist, die durch den Dielektrikumsabschnitt (3a) voneinander elektrisch isoliert sind, wobei die Leitungsabschnitte (3b) jeweils einen Sammelelektrodenabschnitt bilden.

3. Verfahren zur Herstellung einer EAP-Vorrichtung nach Anspruch 1 oder 2, **dadurch gekennzeichnet, dass** der EAP-Stapel (1) eine Sammelelektrode (4) und eine Gegensammelelektrode (5) aufweist, wobei die Sammelelektrode (4) durch einen der Sammelelektrodenabschnitte (3b) der Dielektrikumsschichten (3) und durch einen der Leitungsabschnitte (2a/2c) der Elektrodenschichten (2) gebildet ist und wobei die Gegensammelelektrode (5) durch den anderen Sammelelektrodenabschnitt (3b) der Dielektrikumsschichten (3) und durch den anderen Leitungsabschnitt (2a/2c) der Elektrodenschichten (2) gebildet ist.

4. Verfahren zur Herstellung einer EAP-Vorrichtung nach Anspruch 3, **dadurch gekennzeichnet, dass** die Sammelelektrode (4) als ein Elektrodenkamm und die Gegensammelelektrode als ein Gegenelektrodenkamm ausgebildet sind, wobei der Elektroden- und der Gegenelektrodenkamm ineinander greifen und durch die Isolations- und die Dielektrikumsabschnitte (2b, 3a) elektrisch voneinander isoliert sind.

5. Verfahren zur Herstellung einer EAP-Vorrichtung nach einem der vorhergehenden Ansprüche, **dadurch gekennzeichnet, dass** die Leitungsabschnitte (2a, 2c) und/oder die Sammelelektrodenabschnitte (2a, 2c, 3a) durch elektrisch leitende Additive im EAP gebildet sind.

6. Verfahren zur Herstellung einer EAP-Vorrichtung nach einem der vorhergehenden Ansprüche, **dadurch gekennzeichnet, dass** der mindestens eine EAP-Stapel (1) als ein EAP-Generator ausgebildet ist.

7. Verfahren zur Herstellung einer EAP-Vorrichtung nach Anspruch 6, **dadurch gekennzeichnet, dass** die EAP-Vorrichtung als ein Wellenenergiewandler zur Gewinnung elektrischer Energie aus der Bewegungsenergie von Wasserwellen ausgebildet ist, wobei der EAP-Generator ausgebildet ist, die auf ihn übertragene Bewegungsenergie in die elektrische Energie umzuwandeln.

8. EAP-Vorrichtung, **dadurch gekennzeichnet, dass** die EAP-Vorrichtung durch das Verfahren nach einem der Ansprüche 1 bis 7 hergestellt ist.

## Claims

1. Method for producing an EAP device, the EAP device comprising at least one EAP stack (1),
the at least one EAP stack (1) having a plurality of layers arranged on one another in a longitudinal axis,
the layers comprising electrode and dielectric layers (2, 3),
the dielectric layers (3) being formed as EAP layers each having at least one dielectric section (3a),
the electrode layers (2) being formed as EAP layers each having at least one electrode section (2a),
the electrode and/or dielectric layers (2, 3) being formed as EAP films,
the electrode layer (2) formed as an EAP film having at least two line sections (2a, 2c) in the two-dimensional extent, one of the line sections forming the electrode section (2a) and the other line section forming a collecting electrode section (2c), and the electrode layer (2) formed as an EAP film having an insulation section (2b), which electrically insulates the first and second line section (2a, 2c) from each other,
the electrode layers (2) and dielectric layers (3) being provided as EAP films (2, 3),
the EAP films arranged on one another in a longitudinal axis (A) being joined to one another by means of a film co-extrusion method, and, following the joining, the EAP stack being formed as an endless EAP stack and/or cut up into individual EAP stacks,
the EAP films (2, 3) being provided from at least one endless EAP hybrid film (7) having line and dielectric sections (3a, 3b) and/or line and insulation sections (2a, 2b, 2c) arranged alternately in a longitudinal direction of the endless EAP hybrid film (7)
**characterized in that**
to combine the endless EAP hybrid films (7) to form the EAP stack (1), the endless EAP hybrid films (7) are coated with a hot-melt adhesive and joined to form a laminate.

2. Method for producing an EAP device according to Claim 1, **characterized in that** the dielectric layer (3) formed as an EAP film has at least two line sections (3b) in the two-dimensional extent, which are insulated electrically from each other by the dielectric layer (3a), wherein the line sections (3b) each form a collecting electrode section.

3. Method for producing an EAP device according to Claim 1 or 2, **characterized in that** the EAP stack (1) has a collecting electrode (4) and a mating collecting electrode (5), wherein the collecting electrode (4) is formed by one of the collecting electrode sections (3b) of the dielectric layers (3) and via one of the line sections (2a/2c) of the electrode layers (2), and wherein the mating collecting electrode (5) is formed by the other collecting electrode section (3b) of the dielectric layers (3) and by the other line section (2a/2c) of the electrode layers (2).

4. Method for producing an EAP device according to Claim 3, **characterized in that** the collecting electrode (4) is formed as an electrode comb and the mating collecting electrode is formed as a mating electrode comb, wherein the electrode and the mating electrode comb interengage and are insulated electrically from each other by the insulation and the dielectric sections (2b, 3a).

5. Method for producing an EAP device according to one of the preceding claims, **characterized in that** the line sections (2a, 2c) and/or the collecting electrode sections (2a, 2c, 3a) are formed by electrically conductive additives in the EAP.

6. Method for producing an EAP device according to one of the preceding claims, **characterized in that** the at least one EAP stack (1) is formed as an EAP generator.

7. Method for producing an EAP device according to Claim 6, **characterized in that** the EAP device is formed as a wave energy converter for obtaining electrical energy from the movement energy of water waves, wherein the EAP generator is designed to convert the movement energy transferred to it into electrical energy.

8. EAP device, **characterized in that** the EAP device is produced by the method according to one of Claims 1 to 7.

## Revendications

1. Procédé de fabrication d'un dispositif en EAP, le dispositif en EAP comprenant au moins une pile d'EAP (1),
l'au moins une pile d'EAP (1) possédant une pluralité de couches disposées les unes au-dessus des autres dans un axe longitudinal,
les couches comprenant des couches d'électrode et de diélectrique (2, 3),
les couches de diélectrique (3) étant réalisées sous la forme de couches en EAP ayant respectivement au moins une portion de diélectrique (3a),
les couches d'électrode (2) étant réalisées sous la forme de couches en EAP ayant respectivement au moins une portion d'électrode (2a),
les couches d'électrode et/ou de diélectrique (2, 3) étant réalisées sous la forme de films en EAP,
la couche d'électrode (2) réalisée sous la forme d'un film en EAP possédant dans l'extension plane au moins deux portions de ligne (2a, 2c), l'une des portions de ligne formant la portion d'électrode (2a) et l'autre portion de ligne formant une portion d'électrode collectrice (2c), et la couche d'électrode (2) réalisée sous la forme d'un film en EAP possédant une portion d'isolation (2b) qui isole électriquement l'une de l'autre la première et la deuxième portion de ligne (2a, 2c),
les couches d'électrode (2) et les couches de diélectrique (3) étant fournies sous la forme de films en EAP (2, 3),
les films en EAP étant joints les uns aux autres disposés l'un au-dessus de l'autre dans un axe longitudinal (A) au moyen d'un procédé de coextrusion de films, et après la jonction la pile d'EAP étant réalisée sous la forme d'une pile d'EAP continue et/ou découpée en piles d'EAP individuelles,
les films en EAP (2, 3) étant fournis à partir d'au moins un film hybride continu en EAP (7) ayant des portions de ligne et de diélectrique (3a, 3b) et/ou des portions de ligne et d'isolation (2a, 2b, 2c) disposées en alternance dans un sens longitudinal du film hybride continu en EAP (7),
**caractérisé en ce que**
pour réunir les films hybrides continus en EAP (7) en la pile d'EAP (1), les films hybrides continus en EAP (7) sont enduits d'un adhésif thermofusible et joints en un stratifié.

2. Procédé de fabrication d'un dispositif en EAP selon la revendication 1, **caractérisé en ce que** la couche de diélectrique (3) réalisée sous la forme d'un film en EAP possède au moins deux portions de ligne (3b) dans l'extension plane, lesquelles sont isolées électriquement l'une de l'autre par la portion de diélectrique (3a), les portions de ligne (3b) formant respectivement une portion d'électrode collectrice.

3. Procédé de fabrication d'un dispositif en EAP selon la revendication 1 ou 2, **caractérisé en ce que** la pile d'EAP (1) possède une électrode collectrice (4) et une contre-électrode collectrice (5), l'électrode collectrice (4) étant formée par l'une des portions d'électrode collectrice (3b) des couches de diélectrique (3) et par l'une des portions de ligne (2a/2c) des couches d'électrode (2) et la contre-électrode collectrice (5) étant formée par l'autre portion d'électrode collectrice (3b) des couches de diélectrique (3) et par l'autre portion de ligne (2a/2c) des couches d'électrode (2).

4. Procédé de fabrication d'un dispositif en EAP selon la revendication 3, **caractérisé en ce que** l'électrode collectrice (4) est réalisée sous la forme d'un peigne d'électrodes et la contre-électrode collectrice sous la forme d'un peigne de contre-électrodes, les peignes d'électrodes et de contre-électrodes s'engrenant l'un dans l'autre et étant isolés électriquement l'un de l'autre par les portions d'isolation et de diélectrique (2b, 3a).

5. Procédé de fabrication d'un dispositif en EAP selon l'une des revendications précédentes, **caractérisé en ce que** les portions de ligne (2a, 2c) et/ou les portions d'électrode collectrice (2a, 2c, 3a) sont formées par des additifs électriquement conducteurs dans l'EAP.

6. Procédé de fabrication d'un dispositif en EAP selon l'une des revendications précédentes, **caractérisé en ce que** l'au moins une pile d'EAP (1) est réalisée sous la forme d'un générateur en EAP.

7. Procédé de fabrication d'un dispositif en EAP selon la revendication 6, **caractérisé en ce que** le dispositif en EAP est réalisé sous la forme d'un convertisseur d'énergie houlomotrice destiné à obtenir de l'énergie électrique à partir de l'énergie cinétique des vagues de l'eau, le générateur en EAP étant configuré pour convertir l'énergie cinétique qui lui est transmise en l'énergie électrique.

8. Dispositif en EAP, **caractérisé en ce que** le dispositif en EAP est fabriqué par le procédé selon l'une des revendications 1 à 7.
